Europäisches Patentamt

European Patent Office

Office européen des brevets

(19)

(11) **EP 0 452 609 B1**

(12) **EUROPÄISCHE PATENTSCHRIFT**

| | |
|---|---|
| (45) Veröffentlichungstag und Bekanntmachung des Hinweises auf die Patenterteilung:<br>**10.01.1996 Patentblatt 1996/02** | (51) Int Cl.6: **H03M 1/60**, H03M 3/02,<br>H03M 1/50 |

(21) Anmeldenummer: **90890123.4**

(22) Anmeldetag: **19.04.1990**

(54) **Monolithisch integrierter hochauflösender Analog-Digital-Umsetzer**

High resolution monolithic integrated analog-digital converter

Convertisseur analogique-numérique intégré monolithique à haute résolution

| | |
|---|---|
| (84) Benannte Vertragsstaaten:<br>**AT BE CH DE DK ES FR GB GR IT LI LU NL SE** | (72) Erfinder:<br>• Leopold, Hans, Dr.<br>**A-8043 Graz (AT)**<br>• O'Leary, Paul<br>**A-8010 Graz (AT)** |
| (43) Veröffentlichungstag der Anmeldung:<br>**23.10.1991 Patentblatt 1991/43** | |
| (73) Patentinhaber:<br>**AUSTRIA MIKRO SYSTEME INTERNATIONAL AKTIENGESELLSCHAFT**<br>**A-8141 Unterpremstätten (AT)** | (74) Vertreter: **Gibler, Ferdinand, Dipl.Ing. Dr. techn.**<br>**A-1010 Wien (AT)** |
| | (56) Entgegenhaltungen:<br>**EP-A- 0 367 522**      **DE-A- 2 044 057**<br>**FR-A- 2 235 540** |

**Beschreibung**

Die Erfindung betrifft einen monolithisch integrierten hochauflösenden Analog-Digital-Umsetzer nach dem Ladungsausgleichsverfahren, wobei eine umzusetzende, analoge Eingangsspannung an einen Eingang eines Integrators geführt ist und der Ausgang des Integrators mit dem Steuereingang eines durch einen Taktgeber taktgesteuerten Pulsweitenmodulators verbunden ist, welcher Pulsweitenmodulator ein zweiwertiges, pulsbreitenmoduliertes Ausgangssignal mit einer festen, auf einem starren Zeitraster liegenden Periode und einem veränderlichen Tastverhältnis erzeugt, das die an seinem Eingang anliegende Spannung in diskrete Pulsweiten abbildet, und welches Ausgangssignal über einen Rückführzweig eine Umschalteinheit steuert, die im Tastverhältnis Referenzspannungen an den Eingang des Integrators schaltet, wobei die Integrationsperiode durch ein taktgesteuertes, periodisches Signal, z.B. ein Rampensignal, festgelegt ist, und das Ausgangssignal des Pulsbreitenmodulators einer digitalen Auswerteschaltung zugeführt wird, welche an ihrem Ausgang ein dem analogen Eingangssignal des Analog-Digital-Umsetzers entsprechendes, digitales Signal liefert.

Ein bekanntes Beispiel für eine derartige Architektur ist der klassische Analog-Digital-Umsetzer nach dem Ladungsausgleichsverfahren.

Dieses Konzept zeigt eine nicht-lineare Abhängigkeit der Anzahl der Signalübergänge vom Eingangssignal. Einen Nachteil stellt dabei dar, daß die Schaltzeitfehler bei der Erzeugung des zweiwertigen zeitdiskreten Signals einen Linearitätsfehler des Umsetzers bewirken.

Zur Erzielung einer hohen Auflösung des Analog-Digital-Umsetzers muß das zeitdiskrete Signal während sehr vieler Taktperioden ausgewertet werden, wodurch die Anzahl der abzuwartenden Signalübergänge pro Konversion noch weiter erhöht wird. Dies führt zu einer Begrenzung der maximal bei diesem Verfahren möglichen Genauigkeit.

Aus der FR-A-2 235 540 ist ein Analog-Digital-Umsetzer bekanntgeworden, der einen als Summier-Integrator geschalteten Operationsverstärker umfaßt, dessen invertierender Eingang über einen Widerstand mit dem zu wandelnden Signal verbunden ist und zugleich einen Summiereingang bildet, welcher einerseits über einen Rampen-Kondensator und einen Widerstand mit einem Takt-Rechteckgenerator verbunden ist und andererseits über Schalttransistoren und einen Vorwiderstand an eine positive oder negative Referenzspannungsquelle oder auf Erdpotential schaltbar ist. Der Ausgang des Integrators ist mit zwei Schwellwertkomparatoren mit negativer und positiver Schwellwertspannung verbunden, deren Ausgänge wiederum jeweils mit dem Eingang je eines getakteten Flipflops verbunden sind. Die Ausgänge der Flipflops sind mit einer Auswerteschaltung zur Bestimmung des Tastverhältnisses verbunden und steuern über einen Rückführzweig zugleich die Schalttransistoren und somit das Potential am Vorwiderstand. Über die Bestimmung des Tastverhältnisses wird die Digitalisierung der analogen Eingangsspannung durchgeführt.

Weiters offenbart die FR-A-2 262 807 eine Vorrichtung zur Integration einer elektrischen Spannung, wobei die zu integrierende Spannung über einen Spannungsteiler und einer zum Abgriffswiderstand parallel geschaltetem Kapazität, welche der Vorintegration von höherfrequenten Anteilen der Eingangsspannung dient, einem Eingang eines Komparators zugeführt wird, während der andere Eingang mit einer Parallelschaltung eines Widerstandes und eines Kondensators verbunden ist, die über einen steuerbaren Schalter und eine Konstantstromquelle aufgeladen wird, bis ihre Spannung die Eingangsspannung überschreitet und der Komparator umschaltet. Der Ausgang des Komparators ist über einen Anpasserkreis, der nur zwei exakte logische Zustände annehmen kann, mit dem Eingang eines getakteten Flipflops verbunden, dessen Ausgang wiederum die Schaltfolge des gesteuerten Schalters steuert. Das Tastverhältnis der Ausgangsspannung des Flipflops ist proportional zur Eingangsspannung und wird entsprechend digital weiterverarbeitet.

Das Dokument "Microprocessor Developments" (S.59 bis 62) zeigt einen Pulsmodulations-A/D-Wandler nach dem Ladungsausgleichsverfahren, der in CMOS-Technik integrierbar ist. Die zu wandelnde Eingangsspannung liegt an einem Eingang eines Komparators, dessen Ausgang mit dem Eingang eines getakteten Flipflops verbunden ist, welches zwei FET so steuert, daß die Schwellenspannung des Komparators sich als Mittelwert aus einer Referenzspannung und dem Wert 0 über eine Regelschleife auf den Wert der Eingangsspannung einstellt. Bei Über- oder Unterschreiten der Schwellenspannung wird der Spannungssprung am Komparator jeweils in das Flipflop getaktet. Als Meßgröße zur Digitalisierung dient das Tastverhältnis der Ausgangsspannung des Flipflops.

Aufgabe der Erfindung ist es, die eingangs angeführten Nachteile zu verringern und einen Analog-Digital-Umsetzer nach dem Ladungsausgleichsverfahren anzugeben, bei dem eine wesentlich höhere Genauigkeit als mit den bekannten Umsetzern dieser Art erreichbar ist.

Ferner ist es Ziel der Erfindung den Analog-Digital-Umsetzer in einem Standardprozeß (z.B. Standard CMOS) monolithisch integrierbar zu machen, wobei weder Trimmung der internen Komponenten noch externe Präzisionskomponenten nötig sein sollen. Eine Genauigkeit von z.B. 20 bit soll auch noch für eine Referenzspannung < 1 Volt möglich sein, wobei auch größere Referenzspannungen (z.B. 5 oder 10 Volt) ohne Verschlechterung der Eigenschaften anwendbar sein sollen. Der Eingang des Analog-Digital-Umsetzers soll hohe Eingangsimpedanz und einen kleinen Eingangsstrom aufweisen damit auch hochohmige Sensoren direkt anschließbar sind. Der Analog-Digital-Umsetzer soll weiter ohne Abtast- und Halte-Schaltung verwendbar sein und die Möglichkeit zur Unterdrückung von Netzeinstreuungen bieten.

Diese Aufgabe wird erfindungsgemäß dadurch gelöst, daß der Integrator aus einem Integrator mit einem nichtinvertierenden Eingang und einem invertierenden Eingang gebildet ist, wobei die umzusetzende analoge Eingangsspannung an den nichtinvertierenden Eingang geführt und die Umschalteinheit über den Rückführzweig mit dem invertierenden Eingang verbunden ist.

Diese Schaltungsmaßnahme ergibt einen hochohmigen Spannungseingang für die Meßgröße, wodurch hochohmige Sensoren direkt angeschlossen werden können und erlaubt den Betrieb des gesamten Umsetzers mit nur einer Speisespannung, da für die Funktion des Ladungsausgleichsintegrators Signale nur einer Polarität nötig sind. Weiters ergibt sich der Vorteil, daß durch die Verwendung eines Pulsweitenmodulators zur Erzeugung des an den Ladungsausgleichsintegrator rückgeführten wertdiskreten z.B. zweiwertigen Signals die Anzahl der Signalübergänge während eines Auswerteintervalls wesentlich verringert und genau vorherbestimmbar ist. Dadurch kann die Genauigkeit des Verfahrens wesentlich gesteigert werden. Durch die Diskretisierung des Pulsweitenmodulators und die Erzeugung diskreter Pulsweiten ist die Auswertung der Pulsweiten durch eine digitale Auswerteschaltung fehlerfrei möglich. Die Auflösung des Analog-Digital-Wandlers ist dabei nicht auf die Anzahl der diskreten Pulsweiten beschränkt. Zwischenwerte können in der Auswerteschaltung durch Mittelung über mehrere Taktperioden bestimmt werden. Auf diese Weise ist eine besonders vorteilhafte Synchronisierung der Schaltsignale mit anderen Teilen eines größeren Systems möglich, wodurch Störungen wesentlich vermindert werden können.

Eine weitere Ausgestaltung der Erfindung sieht vor, daß die umzusetzende, analoge Eingangsspannung über ein Anti-Liasing-Filter an den nichtinvertierenden des Eigang Integrators geführt ist.

Dadurch ist ein eventuell notwendiges Antialiasing-Filter ohne großen zusätzlichen Aufwand ergänzbar.

Eine weitere Ausgestaltung der Erfindung mit einem Ladungsausgleichsintegrator, welcher einen Operationsverstärker umfaßt, sieht vor, daß der nichtinvertierende Eingang durch den nichtinvertierenden Eingang und der invertierende Eingang durch den invertierenden Eingang des Operationsverstärkers gebildet ist.

Eine vorteilhafte Ausgestaltung der Erfindung kann darin bestehen, daß der Ladungsausgleichsintegrator aus einem Operationsverstärker, einem Kondensator und einem Widerstand besteht, wobei Kondensator und Widerstand gegebenenfalls in diskreter Technik insbesondere als externe Bauelemente, realisiert sind.

Durch Veränderung des RC-Produktes kann der Ladungsausgleichintegrator an unterschiedliche Taktfrequenzen bzw. Mittelungsintervalle angepaßt werden.

Eine weitere Ausgestaltung der Erfindung besteht darin, daß der Operationsverstärker im Ladungsausgleichsintegrator automatischen Nullabgleich, z.B. Chopperstabilisierung, aufweist.

Durch die Verwendung eines Operationsverstärkers mit automatischem Nullpunktsabgleich wird der Nullpunktsfehler des gesamten Analog-Digital-Umsetzers nur mehr von der Summe der Schaltzeitfehler während einer Konversion bestimmt und damit sehr klein gestaltbar.

Wieder eine andere Ausgestaltung der Erfindung besteht darin, daß der Operationsverstärker im Ladungsausgleichsintegrator Feldeffekttransistoren als Eingangsstufen aufweist.

Es werden durch diese Schaltungsmaßnahme Fehler, die vom Eingangsstrom des Operationsverstärkers im Ladungsausgleichsintegrator hervorgerufen werden, vermieden. Außerdem kann dadurch der Stromrückführwiderstand groß gemacht werden, was gestattet, die Linearitätsfehler, hervorgerufen durch den Unterschied der Quellimpedanzen der das Rückführsignal erzeugenden Quellen, zu minimieren.

Eine weitere Ausgestaltung der Erfindung besteht darin, daß der Analog-Digital-Umsetzer von nur einer Betriebsspannung versorgt wird.

Dies bringt insbesondere den Vorteil, einfache damit kostengünstige und trotzdem sehr hoch auflösende Analog-Digital-Umsetzer zu realisieren.

In weiterer Ausgestaltung der Erfindung kann schließlich die digitale Auswerteschaltung Zähler und/oder digitale Filter enthalten.

Die Verwendung von Zählern und/oder digitalen Filtern in der Auswerteschaltung ermöglicht insbesondere über mehrere Umsetzperioden zu mitteln und damit die Auflösung, verglichen mit herkömmlichen Analog-Digital-Umsetzern, wesentlich zu erhöhen.

Nachstehend ist die Erfindung beispielsweise anhand der Zeichnungen erläutert. In diesen zeigt:

Fig. 1 einen klassischen Analog-Digital-Umsetzer nach dem Ladungsausgleichsverfahren und

Fig. 2 eine beispielhafte Realisierung eines erfindungsgemäßen Analog-Digital-Umsetzers.

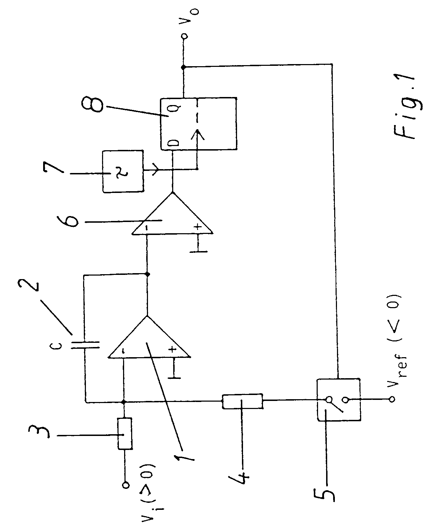

Der Analog-Digital-Umsetzer nach dem Ladungsausgleichsverfahren gemäß Fig. 1 weist einen Ladungsausgleichsintegrator auf, der aus einem Operationsverstärker 1, einem Integrationskondensator 2 und den Skalierungswiderständen 3 und 4 besteht. Der Eingang des Ladungsausgleichsintegrators wird einerseits über den Skalierungswiderstand 3 von der Eingangsspannung $V_i$, andererseits über den Skalierungswiderstand 4 von der über einen steuerbaren Schalter 5 anschaltbaren Referenzspannung $V_{ref}$ beaufschlagt.

Die Ausgangsspannung des Ladungsausgleichsintegrators wird in einem Komparator 6 mit dem Bezugspegel verglichen; das Ergebnis des Vergleichs tritt als zweiwertiges Signal am Ausgang des Komparators 6 auf und der Zustand wird zu den Taktzeitpunkten eines Taktgebers 7 in ein dem Komparator nachgeschaltetes D-Flip-Flop 8 übernommen. Das Ausgangssignal $V_o$ des Flip-Flop stellt sowohl ein Ausgangssignal des Umsetzers als auch das Steuersignal für den steuerbaren Schalter 5 dar.

Es tritt bei dieser Schaltung im Rückführzweig ein zweiwertiges zeitdiskretes Signal, nämlich ein Strom mit den Werten 0 und

$$\frac{V_{ref}}{R_o}$$

auf.

Die Zeitdiskretisierung wird durch den Taktgeber $\tau$ und das D-Flip-Flop FF erreicht, welches nur zu den Zeitpunkten der signifikanten Taktflanken seinen Zustand ändert. Der Operationsverstärker 1 samt Kondensator 2 und der Komparator 6 schließen eine Regelschleife, die dafür sorgt, daß der Mittelwert der elektrischen Ladung, die an den Eingang des Integrators gelangt, zu Null wird. Werden während m Taktperioden n gezählt, in denen das zweiwertige Signal $V_o$ den Zustand high aufweist (also der Schalter 5 geschlossen ist), so gilt:

$$\frac{V_i}{R_1} + \frac{n}{m} \cdot \frac{V_{ref}}{R_0} = 0$$

$$n = -m \cdot \frac{V_i}{V_{ref}} \cdot \frac{R_0}{R_1}$$

$R_1$ = Widerstand 3; $R_o$ = Widerstand 4

Die Auflösung eines derartigen Analog-Digital-Umsetzers hängt von der Größe m ab. Die Zahl der Signalübergänge pro Konversion (also Schaltspiele von 5) wird sehr groß und hängt nichtlinear von n ab. In diesen Tatsachen ist die Genauigkeitsgrenze dieser Art des Ladungsausgleichsverfahrens begründet.

Jeder Übergang des diskreten Signals von einem zum anderen Wert verursacht aufgrund des Schaltzeitfehlers im Schalter 5 einen bestimmten festen Beitrag zum Gesamtfehler. Ein guter Konversionsalgorithmus sollte daher die Zahl der Signalübergänge so klein wie möglich halten und sie überdies konstant oder proportional zur Eingängsgröße des Umsetzers machen. Beide Maßnahmen vermeiden durch Schaltzeitfehler hervorgerufene Linearitätsfehler.

Ein z.B.20 bit genauer Analog-Digital-Umsetzer muß ein zeitwertiges, zeitdiskretes Signal erzeugen, welches für eine Konversion aus etwa 1 Million Zeitinkrementen besteht. Es gibt nun eine sehr große Anzahl von Möglichkeiten, eine Million Signalelemente so anzuordnen, daß ein bestimmter Mittelwert des diskreten Signals entsteht. Da aus der Regelschleife nur eine eindimensionale Stellgröße gewonnen werden kann, müssen durch einschränkende Vorgaben alle überschüssigen Freiheitsgrade der Anordnung der Signalelemente ausgeschlossen werden. Diese Vorschrift muß in einem Generator, der das diskrete Signal erzeugt, berücksichtigt werden.

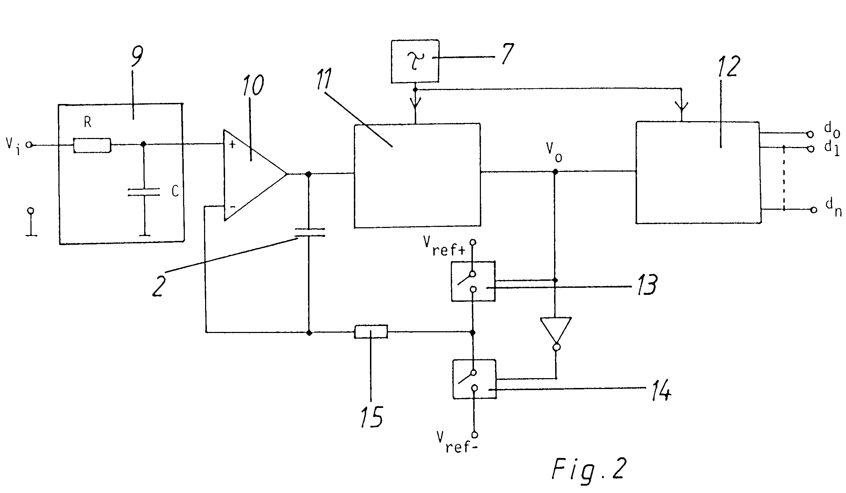

Die Figur 2 zeigt dazu die beispielhafte Ausführung einer erfindungsgemäßen Analog-Digial-Umsetzer-Anordnung. Das Eingangssignal $V_i$ wird über ein wahlweise vorzusehendes Antialiasing-Filter 9, welches im einfachsten Fall aus einen Tiefpaß erster Ordnung besteht, an einen Eingang des Ladungsausgleichsintegrators (Operationsverstärker 10 und Kondensator 2) geführt. Der Ausgang des Ladungsausgleichsintegrators ist mit dem Eingang eines Pulsweitenmodulators 11 verbunden, welcher ein pulsweitenmoduliertes Ausgangssignal $V_o$ erzeugt, dessen Pulsdauer von seiner Eingangsspannung abhängt. Der Pulsweitenmodulator ist bevorzugt von einem im Taktgenerator 7 erzeugten Takt gesteuert.

Der Pulsweitenmodulator 11 kann z.B. durch eine Komparator gebildet werden der ein taktgesteuertes periodisches Rampensignal mit der Ausgangsgröße des Ladungsausgleichsintegrators 10 vergleicht, wobei an die Linearität des Rampensignals keine großen Forderungen gestellt werden, da der durch eine Nichtlinearität hervorgerufene Linearitätsfehler um die Schleifenverstärkung des Regelkreise verringert wird. Als Rampensignal wird der leichteren monolithischen Integrierbarkeit wegen bevorzugt ein R-C-Ladesignal verwendet.

Zweckmäßig erzeugt der taktgesteuerte Pulsweitenmodulator 11 mit einer Periode von etwa 1000 μs Impuls, deren Weite in Inkrementen von 1 μs quantisiert ist. Dieser Pulsweitenmodulator 11 bildet die Stellgröße aus dem Ladungsausgleichsintegrator in Form der Impulsweite diskret ab. Das pulsweitenmodulierte Signal $V_o$ wird einerseits einer digitalen Auswerteschaltung 12 zugeführt, andererseits steuert es zueinander komplementär die Schalter 13 und 14, die den Rückführungseingang des Ladungsausgleichsintegrators über einen Widerstand 15 alternierend an die beiden festen Spannungen $V_{ref+}$ und $V_{ref-}$ legen. Wird die Eingangsspannung $V_i$ des Analog-Digital-Umsetzers dem nichtinvertierenden Eingang des Operationsverstärkers 10 zugeführt, so ergibt diese Schaltungsmaßnahme einen hochohmigen Spannungseingang für die Meßgröße und erlaubt den Betrieb des gesamten Umsetzers mit nur einer Speisespannung.

Der beschriebene Regelkreis stellt insgesamt einen Delta-Sigma-Konverter erster Ordnung mit einem 10 bit Analog-Digital-Konvertor im Vorwärtszweig und einer Abtastfrequenz von z.B. ein Kilohertz dar. Die theoretische Auflösung R dieses Konzeptes läßt sich mit R $\doteq$ 1,5 x $\log_2$ ROS + N zu etwa 25 bit bei einer Überabtastung ROS von 1000 und einer Analog-Digital-Umsetzer Auflösung N von 10 bit im Vorwärtszweig angeben.

Die Funktion der Schleife ist folgende: Die Spannung am Ausgang des Operationsverstärkers 10 wird jenen Wert annehmen, der in der betrachteten Periode jene Pulsweite zur Folge hat, die den bestmöglichen Ladungsausgleich im Integrationskondensator 2 herbeiführt. Da die Pulsweite quantisiert ist, kann vollkommener Ladungsausgleich nur für bestimmte Werte der Eingangsspannung erreicht werden. Die nicht ausgeglichenen Ladungsreste aus den einzelnen Perioden des Pulsweitenmodulators 11 laden den Integrationskondensator 2 so lange um, bis der Pulsweitenmodulator 11 die nächstgrößere oder nächstkleinere Pulsweite (je nach Richtung der Restladung) während einer Periode einstellt. Dadurch wird die Richtung der Restladung umgekehrt und der Pulsweitenmodulator 11 kehrt zur ursprünglichen Pulsweite zurück. Bei konstanter Eingangsspannung $V_i$ des Umsetzers erzeugt der Pulsweitenmodulator 11 nur zwei benachbarte Werte der Pulsweite, aus deren Häufigkeit die weitere, über die Auflösung des Pulsweitenmodulators 11 hinausgehende Information gewonnen wird. Wenn z.B. 1000 Perioden eines 1000-schrittigen Pulsweitenmodulators abgelaufen sind, stehen eine Million diskrete Signalelemente zur Auswertung zur Verfügung (entsprechend einer Auflösung von 20 bit). Dieser Ablauf der 1000 Perioden mit Speicherung der Restladung kann auch als eine 1000-fache Überabtastung eines 10 bit Analog-Digital-Umsetzers mit entsprechender Unterdrückung des Quantisierungsgeräusches durch Verschiebung des Schwerpunktes des Störspektrums (noise shaping) verstanden werden.

Durch Verknüpfung des Steuertaktes für den Pulsweitenmodulator mit der Frequenz des Versorgungsnetzes sind Einstreuungen aus dem Versorgungsnetz in das umzuwandelnde Signal leicht unterdrückbar.

Die Spannung am Integrationskondensator 2 bleibt bei konstanter Eingangsspannung $V_i$ annähernd konstant, daher werden trotz der hohen Auflösung von 20 bit keine besonderen Ansprüche an den Kondensator betreffend die dielektrische Absorption gestellt was die monolithische Integration des Kondensators ermöglicht.

Der Nullpunktfehler des in Fig. 2 gezeigten Analog-Digital-Umsetzers setzt sich aus dem Nullpunktfehler des Operationsverstärkers 10 und der Summe der Schaltzeitfehler während einer Konversion zusammen. Der Beitrag des Operationsverstärkers 10 kann durch automatische Nullpunktkorrektur unter 0,5 µV gebracht werden. Es wird daher bevorzugt ein chopper stabilisierter Operationsverstärker welcher in monolothischer Technik ohne Abgleich herstellbar ist verwendet. Dieser Operationsverstärker beansprucht den überwiegenden Teil der Chipfläche der analogen Teilschaltung. Wird für ein Schaltspiel der Schalter 13 und 14 ein Zeitfehler <1 ns angenommen, so bleibt der summierte Schaltzeitfehler während 1000 Perioden des Pulsweitenmodulators 11 unter 1 µs. Das entspricht 1 LSB von 20 bit. Da die Zahl der Schaltspiele pro Konversion nicht von der Größe der Eingangsspannung des Umsetzers abhängt, verursachen die Schaltzeitfehler keinen nennenswerten Steigungsfehler. Der Steigungsfehler wird in erster Linie durch die Gleichtaktunterdrückung des Operationsverstärkers 10 bestimmt. Der Unterschied der Einschaltwiderstände der Schalter 13 und 14 verursachen einen Linearitätsfehler, dessen Größe von dem Verhältnis dieser Differenz zur Größe des Widerstandes 15 abhängt. Um den Widerstand 15 daher groß machen zu können und gleichzeitig eine kleine Strombelastung der zu messenden Spannung $V_i$ zu erreichen, werden im Operationsverstärker 11 Feldeffektransistoren als Eingangsstufen verwendet. Bei ratiometrischer Verwendung des in Fig. 2 gezeigten Analog-Digital-Umsetzers ist zu beachten, daß die Innenwiderstände der Spannungsquellen $V_{ref+}$ und $V_{ref-}$ zu den Einschaltwiderständen der Schalter 13 und 14 hinzuzuzählen sind. Es müssen daher im Falle hochohmiger Quellen Spannungsfolger verwendet werden.

Zur sicheren Erreichung einer Genauigkeit von 20 Bit sind maximale Widerstandsunsymmetrien von etwa 4 Ohm bei einem Rückführwiderstand 15 von einem Megaohm zulässig. Dies stellt für die monolithische Integration eine anspruchsvolle jedoch lösbare Forderung dar.

## Patentansprüche

1. Monolithisch integrierter hochauflösender Analog-Digital-Umsetzer nach dem Ladungsausgleichsverfahren, wobei eine umzusetzende, analoge Eingangsspannung ($V_i$) an einen Eingang eines Integrators (1; 10) geführt ist und der Ausgang des Integrators (1; 10) mit dem Steuereingang eines durch einen Taktgeber (7) taktgesteuerten Pulsweitenmodulators (8; 11) verbunden ist, welcher Pulsweitenmodulator (8; 11) ein zweiwertiges, pulsbreitenmoduliertes Ausgangssignal mit einer festen, auf einem starren Zeitraster liegenden Periode und einem veränderlichen Tastverhältnis erzeugt, das die an seinem Eingang anliegende Spannung in diskrete Pulsweiten abbildet, und welches Ausgangssignal über einen Rücktührzweig eine Umschalteinheit (5; 13, 14) steuert, die im Tastverhältnis Referenzspannungen ($V_{ref+}$, $V_{ref-}$) an den Eingang des Integrators (1; 10) schaltet, wobei die Integrationsperiode durch ein taktgesteuertes, periodisches Signal, z.B. ein Rampensignal, festgelegt ist, und das Ausgangssignal des Pulsbreitenmodulators (8; 11) einer digitalen Auswerteschaltung (12) zugeführt wird, welche an ihrem Ausgang ein dem analogen Eingangssignal des Analog-Digital-Umsetzers entsprechendes, digitales Signal liefert, **dadurch gekennzeichnet**, daß der Integrator aus einem Integrator (10) mit einem nichtinvertierenden Eingang und einem invertierenden Eigang gebildet ist, wobei die umzusetzende analoge Eingangsspannung ($V_i$) an den nichtinvertierenden Eingang geführt und die Umschalteinheit (13, 14) über den Rückführzweig mit dem invertierenden Eingang verbunden ist.

2. Monolithisch integrierter hochauflösender Analog-Digital-Umsetzer nach Anspruch 1, **dadurch gekennzeichnet**, daß die umzusetzende, analoge Eingangsspannung ($V_i$) über ein Antialiasing-Filter (9) an den nichtinvertierenden des Eingang Integrators (10) geführt ist.

3.  Monolithisch integrierter hochauflösender Analog-Digital-Umsetzer nach Anspruch 1 oder 2, welcher einen Operationsverstärker (10) umfaßt, **dadurch gekennzeichnet,** daß der nichtinvertierende Eingang durch den nicht-invertierenden Eingang (+) und der invertierende Eingang durch den invertierenden Eingang (-) des Operationsverstärkers (10) gebildet ist.

4.  Monolithisch integrierter hochauflösender Analog-Digital-Umsetzer nach einem der Ansprüche 1 bis 3, **dadurch gekennzeichnet,** daß der Integrator aus einem Operationsverstärker, einem Kondensator und einem Widerstand besteht, wobei Kondensator und Widerstand gegebenenfalls in diskreter Technik, insbesondere als externe Bauelemente, realisiert sind.

5.  Monolithisch integrierter hochauflösender Analog-Digial-Umsetzer nach Anspruch 4, **dadurch gekennzeichnet,** daß der Operationsverstärker des Integrators automatischen Nullabgleich, z.B. Chopperstabilisierung, aufweist.

6.  Monolithisch integrierter hochauflösender Analog-Digital-Umsetzer nach einem der Ansprüche 4 oder 5, **dadurch gekennzeichnet,** daß der Operationsverstärker im Integrator Feldeffekttransistoren als Eingangsstufen aufweist.

7.  Monolithisch integrierter hochauflösender Analog-Digital-Umsetzer nach einem der Ansprüche 1 bis 6, **dadurch gekennzeichnet**, daß der Analog-Digital-Umsetzer von nur einer Betriebsspannung versorgt ist.

8.  Monolithisch integrierter hochauflösender Analog-Digital-Umsetzer nach einem der Ansprüche 1 bis 7, **dadurch gekennzeichnet**, daß die digitale Auswerteschaltung Zähler und/oder digitale Filter enthält.

**Claims**

1.  High-resolution monolithic integrated analog-digital converter using the charge balancing method, an analog input voltage ($V_i$) to be converted being passed to an input of an integrator (1; 10) and the output of the integrator (1; 10) being connected to the control input of a pulse width modulator (8; 11) clocked by a clock generator (7), which pulse width modulator (8; 11) produces a two-value pulse-width-modulated output signal having a fixed period in a rigid time frame and having a variable duty ratio, which maps the voltage present across the input of the said modulator into discrete pulse widths, and which output signal controls, via a feedback path, a changeover unit (5; 13, 14) which connects, at the duty ratio, reference voltages ($V_{ref+}$, $V_{ref-}$) to the input of the integrator (1; 10), the integration period being defined by a clocked periodic signal, for example a ramp signal, and the output signal of the pulse width modulator (8; 11) being fed to a digital evaluation circuit (12) which delivers at its output a digital signal corresponding to the analog input signal of the analog-digital converter, characterized in that the integrator is formed by an integrator (10) having a non-inverting input and an inverting input, the analog input voltage ($V_i$) to be converted being passed to the non-inverting input and the changeover unit (13, 14) being connected to the inverting input via the feedback path.

2.  High-resolution monolithic integrated analog-digital converter according to Claim 1, characterized in that the analog input voltage ($V_i$) to be converted is passed to the non-inverting input of the integrator (10) via an anti-aliasing filter (9).

3.  High-resolution monolithic integrated analog-digital converter according to Claim 1 or 2, which comprises an operational amplifier (10), characterized in that the non-inverting input is formed by the non-inverting input (+) and the inverting input is formed by the inverting input (-) of the operational amplifier (10).

4.  High-resolution monolithic integrated analog-digital converter according to one of Claims 1 to 3, characterized in that the integrator comprises an operational amplifier, a capacitor and a resistor, the capacitor and the resistor being implemented, if desired, using discrete technology, in particular as external components.

5.  High-resolution monolithic integrated analog-digital converter according to Claim 4, characterized in that the operational amplifier of the integrator has automatic zero balancing, for example chopper stabilization.

6.  High-resolution monolithic integrated analog-digital converter according to one of Claims 4 and 5, characterized in that the operational amplifier in the integrator has field-effect transistors as the input stages.

7.  High-resolution monolithic integrated analog-digital converter according to one of Claims 1 to 6, characterized in that the analog-digital converter is supplied by only one operating voltage.

8.  High-resolution monolithic integrated analog-digital converter according to one of Claims 1 to 7, characterized in that the digital evaluation circuit contains counters and/or digital filters.

## Revendications

1. Convertisseur analogique-numérique monolithique, intégré, à haute résolution, selon le procédé de compensation de charge, une tension d'entrée ($V_i$) analogique, à convertir, étant amenée à une entrée d'un intégrateur (1 ; 10) et la sortie de l'intégrateur (1 ; 10) étant reliée à l'entrée de commande d'un modulateur de largeur d'impulsion (8 ; 11) à commande cadencée au moyen d'un cadenceur (7), ce modulateur de largeur d'impulsion (8 ; 11) produisant un signal de sortie à deux valeurs, à modulation de largeur d'impulsion, à période fixe, placée suivant une trame temporelle rigide, et produisant un taux d'exploration modifiable, donnant une illustration, par largeurs d'impulsion discrètes, de la tension appliquée à son entrée, et le signal de sortie commandant, par l'intermédiaire d'une branche de retour, une unité de commutation (5 ; 13 ; 14) assurant, suivant le taux d'exploration, la commutation de tensions de référence ($V_{ref+}$, $V_{ref-}$) à l'entrée de l'intégrateur (1 ; 10), la période d'intégration étant fixée au moyen d'un signal périodique, commandé selon une cadence, par exemple un signal en rampe, et le signal de sortie du modulateur de largeur d'impulsion (8 ; 11) étant amené à un circuit d'évaluation numérique (12), qui fournit à sa sortie un signal correspondant au signal d'entrée analogique du convertisseur analogique-numérique, caractérisé en ce que l'intégrateur est constitué d'un intégrateur (10) doté d'une entrée non-inverseuse et d'une entrée inverseuse, la tension d'entrée analogique ($V_i$) à convertir étant menée à l'entrée non-inverseuse et l'unité de commutation (13, 14) étant reliée à l'entrée inverseuse, par l'intermédiaire de la branche de retour.

2. Convertisseur analogique-numérique monolithique, intégré, à haute résolution, selon la revendication 1, caractérisé en ce que la tension d'entrée analogique ($V_i$) à convertir est amenée à l'entrée non inverseuse de l'intégrateur (10), par l'intermédiaire d'un filtre antirepliement de spectre (9).

3. Convertisseur analogique-numérique monolithique, intégré, à haute résolution, selon l'une des revendications 1 ou 2, comprenant un amplificateur opérationnel (10), caractérisé en ce que l'entrée non-inverseuse est constituée par l'entrée non-inverseuse (+), et l'entrée inverseuse par l'entrée inverseuse (-) de l'amplificateur opérationnel (10).

4. Convertisseur analogique-numérique monolithique, intégré, à haute résolution, selon l'une des revendications 1 à 3, caractérisé en ce que l'intégrateur est constitué d'un amplificateur opérationnel, d'un condensateur et d'une résistance, le condensateur et la résistance étant, le cas échéant, réalisés selon une technique discrète, en particulier sous forme de composants externes.

5. Convertisseur analogique-numérique monolithique, intégré, à haute résolution, selon la revendication 4, caractérisé en ce que l'amplificateur opérationnel de l'intégrateur présente une compensation de zéro automatique, par exemple une stabilisation par découpage.

6. Convertisseur analogique-numérique monolithique, intégré, à haute résolution, selon la revendication 4 ou 5, caractérisé en ce que l'amplificateur opérationnel se trouvant dans l'intégrateur présente, comme étage d'entrée, des transistors à effet de champ.

7. Convertisseur analogique-numérique monolithique, intégré, à haute résolution, selon l'une des revendications 1 à 6, caractérisé en ce que le convertisseur analogique-numérique n'est alimenté que par une seule tension de service.

8. Convertisseur analogique-numérique monolithique, intégré, à haute résolution, selon l'une des revendications 1 à 7, caractérisé en ce que le circuit d'évaluation numérique contient des compteurs et/ou des filtres numériques.

Fig.1

Fig. 2